# EUROPEAN PATENT APPLICATION

(11) **EP 1 755 368 A2**
(43) Date of publication of application: **21.02.2007**
(21) Application number: 06119054.2
(22) Date of filing: 17.08.2006
(51) Int. Cl.: H05K 7/20

(54) **Cooling system and method for cooling electronic devices**

(30) Priority: 17.08.2005 NL 1029750
(71) Applicant: Isolectra B.V., 2909 LK Capelle aan den Ijssel (NL)
(72) Inventor: Klamer, Jan, 2902 KL, Capelle aan den Ijssel (NL)
(74) Representative: Brouwer, Hendrik Rogier

(57) **Abstract**

The invention relates to a cooling system for cooling electronic devices (102). The cooling system is provided with first cooling means (2,100) for cooling a first cooling medium (100) present in the device, and is also provided with second cooling means (110,111) for cooling a second cooling medium present in the first cooling means, this second cooling means comprising a conduit system which can be arranged in the ground, transport means for the second cooling medium (110,111) in the conduit system and connecting means for connecting to the first cooling means.

## Description

The invention relates to a cooling system and method for cooling electronic devices.

Electronic devices generally comprise electrical and/or electronic components which are shielded from the outside world by a housing. Examples of such electronic devices are computers, telephone connection boxes, high-voltage houses and the like. Electronic devices are often provided in practice with a cooling system in order to prevent exposure of the components to excessively high temperatures. An increase in temperature can occur due to outside influences, such as for instance the action of sunlight, but is generally also generated by development of heat in the components themselves. A known and frequently applied cooling system for electronic devices comprises a fan which is able to draw in a first cooling medium (generally ambient air) and carry it along the components. If desired, the first cooling medium can be cooled in the known cooling system by guiding it along a suitable heat exchanger, as for instance takes place in an air conditioning system ("airco").

The known cooling system for electrical and electronic housings has various drawbacks. The operation thereof can for instance be disrupted relatively easily by an external cause. When a fan is used which draws in outside air, foreign objects such as flies or other small animals and/or dust can for instance easily be drawn in. The operation thereof can also be seriously disrupted if the opening along which ambient air is drawn in is closed off. This occurs increasingly often in devices which are placed in a public area and which can therefore be accessed without much difficulty by vandals. Such individuals are then tempted to block the inlet opening of the known system (or possibly also the outlet opening) with for instance polyurethane foam, and to then set this alight, with all the consequences this entails. In addition to the known cooling system being insufficiently vandal-proof, a further drawback is that it has a relatively low efficiency. In the context of this application efficiency is understood to mean the energy required to discharge a determined amount of energy (heat). A measure hereof which is known to the skilled person is the so-called Coefficient of Performance (COP). The known cooling system, for instance of the airco-type, generally has a COP of only about 1, which means that about 1 kW of electrical energy is required per kW of thermal energy to be discharged.

The invention has for its object to provide a cooling system and method for cooling electronic devices which have, among other things, an improved resistance to vandalism and an increased efficiency.

The device according to the invention has for this purpose the features as described in the characterizing part of claim 1.

By providing the device according to the invention with first cooling means for cooling a first cooling medium present in the device, and also providing it with second cooling means for cooling a second cooling medium present in the first cooling means, this second cooling means comprising a conduit system to be arranged in the ground, transport means for the second cooling medium in the conduit system and connecting means for connecting to the first cooling means, a cooling system with an improved efficiency is obtained. According to the invention the first cooling medium is intended to come into heat-exchanging contact with the components of the electrical and/or electronic device. The second cooling medium supplied by the second cooling means is particularly intended to keep the first cooling medium at the desired cooling temperature. According to the invention the conduit system is in practice arranged up to a determined depth in the ground. The second cooling medium present in the conduit system is then set into flow by means of suitable transport means such as for instance a pump. During the underground part of the flow the second cooling medium gradually takes on the average temperature of the ground, which will generally be significantly lower than the average temperature of the components. Via the connecting means the second cooling medium is carried to the first cooling means, where heat exchange can take place with the first cooling medium. Because this first cooling medium is intended to come into heat-exchanging contact with the components, this first cooling medium will preferably be a gas, more preferably an at least partly inert gas, and most preferably air. It has been found that a considerable contribution toward the increase in efficiency is made by making use according to the invention of the relatively cool ground, wherein the great thermal inertia of the ground is utilized. Because the second cooling medium, which must keep the first cooling medium at the desired temperature, does after all no longer require cooling, or possibly requires only additional cooling, the cooling system according to the invention does not have to comprise an (additional) cooling unit, and this saves energy. The energy required for pumping the second cooling medium around in the conduit system can furthermore be considerably lower than would be necessary for such a cooling unit.

The cooling means required for achieving sufficient cooling capacity in the known cooling system generally cause much noise nuisance. This can cause great problems, especially for electronic devices which have to be arranged at locations which are much-frequented by people (public places, public roads and so on). The cooling system according to the invention has the additional advantage that it can be operated with lower noise, since a higher efficiency and cooling capacity can be achieved herewith than with the known cooling system. With the cooling system according to the invention it is thus possible to achieve a sound production which is lower than 60 dB, and even lower than 40 dB, at a capacity of 1 kW.

A further advantage of the cooling system according to the invention is that it can be practically closed in practice, in contrast to known cooling systems which must draw in ambient air. This prevents dust entering the cooling system and/or the housing of the electronic device, which enhances operation thereof and reduces maintenance. It further becomes possible to insulate the (housing of the) electronic device thermally and/or acoustically from the surrounding area.

A further advantage is that at least a part of the conduit system can be positioned in the immediate vicinity of the electrical and/or electronic components since it requires little space. Cooling can thus be applied in efficient manner and only where it is necessary.

According to the invention the second cooling medium is brought to its desired cooling temperature by allowing this medium to flow in the conduit system. Because the conduit system is in at least partly heat-exchanging contact with the relatively cool ground, it is cooled herein. It does not matter here whether the conduit system comprises a closed circuit in which an at least temporarily enclosed second cooling medium is situated, or whether the conduit system is interrupted somewhere, for instance in the part which in practice is situated underground. In this latter embodiment the second cooling medium can for instance be suctioned up from the ground in the form of groundwater, wherein at least one open end of the conduit system is positioned such that groundwater can hereby be drawn in without this costing too much pumping energy. It is also possible in practice to position the feed conduit such that it can suction up surface water. In the context of this application surface water is understood to mean any water mass which is at least partially exposed to the air, such as for instance the water in ditches.

In a preferred embodiment the cooling system according to the invention is characterized in that the second cooling means comprise an open conduit system with at least one feed conduit which can extend into the underground water table and through which groundwater can be suctioned up. Such a cooling system has an improved efficiency since the second cooling medium already has the desired, relatively low temperature when it is drawn up, and no energy is therefore required for further cooling thereof. A feed conduit which can extend into the underground water table is otherwise understood to mean that, in this embodiment, the cooling system has a feed conduct which is suitable for this purpose, and which in other words is inter alia long enough, sufficiently rigid and sufficiently strong to withstand the forces which occur, is sufficiently corrosion-resistant and so on. In this embodiment the groundwater which has been suctioned up is discharged via the discharge part of the conduit system after the heat exchange with the first cooling medium (wherein the second cooling medium has acquired at least a different temperature, which will generally be higher in a cooling system). In an embodiment variant of the cooling system the discharge conduit is positioned in practice such that it runs out in surface water. It is also possible to have the discharge conduit run out into a collecting unit for the second cooling medium and/or into the sewer.

In a particular embodiment the cooling system is characterized in that the second cooling means comprise an open conduit system with at least one discharge conduit which can extend into the underground water table and through which the groundwater can be discharged. Discharge of the second cooling medium to the ground, and preferably into the underground water table, after heat exchange with the first cooling medium achieves that no further treatment thereof is necessary, such as for instance a partial cooling. In this embodiment it can also be advantageous to position the open ends of the discharge conduit and the feed conduit in the ground such that there is a groundwater flow therebetween. Such a groundwater flow may already have resulted in natural manner or, if desired, can be generated by mechanical means suitable for this purpose and known to the skilled person.

It is however advantageous to characterize the cooling system in that the second cooling means comprise a substantially closed conduit system which can extend at least into the ground, wherein the conduit system is provided with the second cooling medium. This preferred embodiment achieves that practically no material interaction can take place between the second cooling medium and the ground. This can have great advantages in respect of preventing possible damage to the environment. For this embodiment it is therefore possible in accordance with Dutch regulations that it is not necessary to apply for a permit for discharge of the second cooling medium. In the present invention it further becomes possible to select a second cooling medium with properties which are optimally adapted to the specific requirements of a determined situation. The rheological properties, such as for instance viscosity, the thermodynamic properties, such as for instance the heat capacity, and possible other relevant properties can thus for instance be set in accordance with requirements.

During operation the conduit system of the cooling system according to the invention is arranged at least partially in the ground. The depth at which this takes place is not of essential importance to the invention, as long as the second cooling medium is cooled sufficiently to be able to meet the desired requirements. The depth to which the conduit system can extend into the ground can be adjusted in simple manner subject to for instance the desired cooling capacity. It is however advantageous when the cooling system according to the invention is provided with a conduit system which can extend into the ground to at least a depth of about 3 m, and more preferably to at least about 6 m. This measure achieves that the second cooling medium will have a more constant temperature when being drawn in than when the conduit system is arranged to lesser depths in the ground. A more constant temperature is understood to mean that it will vary less around the average temperature, which can be calculated over periods of time from hours to months. In other words, the temperature of the second cooling medium will display fewer variations per hour, and/or per day, and/or per month. This further enhances the reliability of the cooling system. By having the conduit system extend to a depth of at least about 6 m into the ground a higher cooling capacity is moreover achieved. It has otherwise been found that the cooling capacity has an optimum for depths lying between about 3 - 30 m, more preferably between about 6 - 20 m, most preferably between 8 - 15 m.

In a further preferred embodiment the cooling system comprises a conduit system, at least a part of which runs approximately horizontally after arranging thereof in the ground. This further enhances inter alia the reliability and the efficiency. This embodiment is of further advantage when it is found impossible to reach greater depths, for instance because the nature of the ground does not allow this. Although not necessary for the invention, it is also advantageous to characterize the cooling system according to the invention in that the conduit system has a total length such that the second cooling medium will almost have the average temperature of the ground when it enters the first cooling means. If conditions make reaching a great length difficult, the second cooling means can, if desired, comprise at least one heat exchanger for heat exchange between the second cooling medium and the ground.

In order to at least partly prevent possible blockage of the conduit system, the cooling system is preferably provided with second cooling means which are provided with at least one filter along which the second cooling medium can be guided. This measure further increases the efficiency of the cooling system and at least partially prevents the deterioration thereof in the longer term.

According to the invention the above described second cooling means of the cooling system can be connected to the first cooling means via the connecting means. It is for instance possible in practice to accommodate the first cooling means in the housing of an electronic device together with connecting means which can connect via the housing to the second cooling means. It will be apparent that many known possibilities are available to the skilled person here. During operation the second cooling medium is carried to the first cooling means, where heat exchange with the first cooling medium can take place. The first cooling means serve solely to bring about heat exchange between the second cooling medium, which is preferably not brought into immediate contact with the electrical or electronic components, and the first cooling medium, which is suitable for this purpose. If the second cooling medium is also suitable for bringing into direct contact with the components, the first cooling means are then not therefore necessary. It is possible in practice that the first cooling means form part of the conduit system of the second cooling means, this part then being preferably located in the housing of the electrical device. Heat exchange then takes place via the wall of this conduit system part. Another possibility consists of accommodating the electronic components in their own housing, which is flexible if necessary and around which the second cooling medium is set into flow during operation. The first cooling medium then comprises the gas, for instance air, present in its own housing.

In a preferred embodiment the cooling system according to the invention is provided with first cooling means comprising at least one heat exchanger for heat exchange between the second and the first cooling medium. This further increases the efficiency of the cooling system. Various commercially available heat exchangers can be applied as heat exchanger. It has been found that a cooling system is particularly suitable in which the first cooling means comprise a heat exchanger with a first space in which the first cooling medium can flow, and a second space in which the second cooling medium can flow, and heat-conducting means therebetween and in thermal contact with both spaces and comprising a large number of heat-conducting threads in the form of a strip or mat. In combination with the second cooling means an exceptionally high cooling efficiency can be achieved with such a heat exchanger. Cooling efficiencies expressed as COP which can be obtained with the present preferred embodiment amount to at least 5 and preferably at least 10. The above described heat exchanger, which is particularly suitable for the object of the present invention, is for instance described in the PCT patent publication WO 95/05570, the content of which is explicitly included herein. Such a heat exchanger is for instance commercially available from the firm Fiwihex in the Netherlands.

Even higher levels of efficiency can be obtained by further providing the cooling system according to the invention with first cooling means comprising at least one fan for circulating the first cooling medium, which preferably comprises air present in the electronic device.

If desired, the cooling system, and in particular the part which can be accommodated in the housing of an electronic device, can be provided with a drip-tray and drain for condensation water.

The cooling system according to the invention can be installed by providing a housing which comprises at least first cooling means and connecting means for the second cooling means. The second cooling means are arranged in the ground using methods known for this purpose. It is thus possible for instance to arrange a drilled opening in the ground and to arrange the conduit system therein. The ground can also be excavated, whereafter the ground is filled again after placing of the conduit system. When the conduit system is arranged, it can be advantageous to apply an encasing construction, especially in grounds which subside relatively easily. In such an embodiment the space between the ground and the conduit system can, if desired, be filled with a thermally conductive material. It will be apparent that a number of solutions are available here to the skilled person. After placing of the conduit system the first cooling means can then be arranged on the second cooling means via the connecting means. If a closed conduit system is applied, it must be filled beforehand with second cooling medium, for instance water.

The invention will now be further elucidated on the basis of the non-limitative preferred embodiment of a device according to the invention described in the figures. Herein:
- figure 1 shows a schematic perspective view of a part of the cooling system according to the invention;
- figure 2 shows a schematic section in side view of a part of the cooling system;
- figure 3 shows a schematic section in top view of a part of the cooling system;
- figure 4 shows a schematic view of the cooling system according to the invention in connected position.

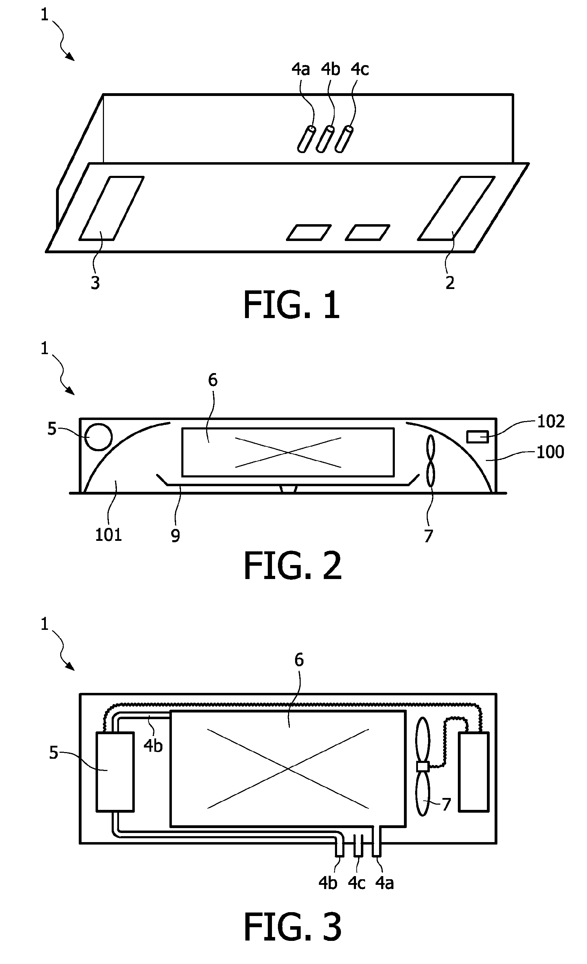

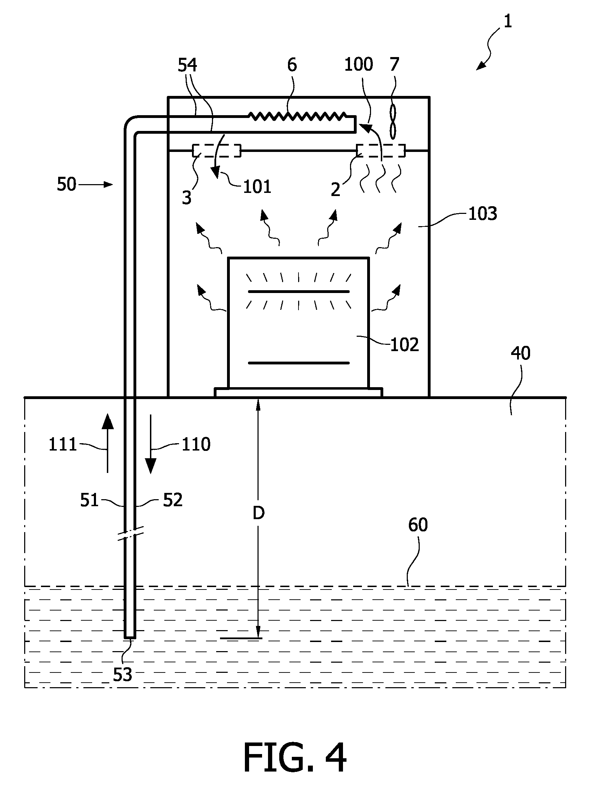

Referring to figures 1-3, a first embodiment of the cooling system comprises a housing 1 which is provided with an inlet 2 for the first cooling medium 100 heated by the electrical and/or electronic components 102. In the embodiment shown in figures 1-3 this medium 100 is situated in the space enclosed by housing 1. In another embodiment as shown in figure 4 it is however also possible for this heated cooling medium 100 to be supplied by fan 7 from space 103, where components 102 are located. The cooling system further comprises an outlet 3 for cooled first cooling medium 101, and first cooling means in the form of a liquid/gas heat exchanger 6 for cooling the first cooling medium (designated with 100 in heated state, with 101 in cooled state) present in the device. The system is also provided with connections 4 (feed 4a, discharge 4b and overflow 4c) for second cooling means, which comprise a conduit system 50 (not shown in figures 1-3), a part 54 of which runs through housing 1 of the system. Conduit system 50 contains a suitable second cooling medium, for instance water (designated with 110 in heated state, with 111 in cooled state). In the connected situation a large part of conduit system 50 is situated in the ground 40 and extends for instance to a depth D. In the shown example this depth D is about 40 m. The second cooling medium (110,111) is transported in conduit system 50 by means of a pump 5. Conduit system 50 and heat exchanger 6 are mutually connected by means of connecting means suitable for this purpose (not shown). Conduit system 50 comprises at least one feed conduit 51 and a discharge conduit 52 which, as shown in figure 4, form a closed circuit in the shown embodiment, since both conduits 51, 52 are connected by means of conduit part 53. According to the embodiment shown in figure 4, conduit system 50 extends into the underground water table 60.

If desired, the system is provided with a collecting tray 9, optionally with overflow and provided with a sensor for collecting and recording for instance a quantity of condensation, and/or a quantity of second cooling medium, in the case of leakage.

During operation pump 5 will pump round the second cooling medium present in conduit system 50, as indicated by means of arrows 110 and 111. The medium 111 cooled by heat exchange with ground 40 will be guided via connections 4a to heat exchanger 6. Heated first cooling medium is drawn in from space 103 by fan 7 and carried along heat exchanger 6, whereby this medium cools and, in cooled state 101, is fed back via outlet 3 into space 103, where electronic components 102 are situated. The cooled second medium 111 will be heated by heat exchange via exchanger 6. Via discharge conduit 52 this heated medium 110 is fed back to the ground 40, where it is once again cooled.

## Claims

1. Cooling system for electronic devices, provided with first cooling means for cooling a first cooling medium present in the device, also provided with second cooling means for cooling a second cooling medium present in the first cooling means, this second cooling means comprising a conduit system which can be arranged in the ground, transport means for the second cooling medium in the conduit system and connecting means for connecting to the first cooling means.

2. Cooling system as claimed in claim 1, **characterized in that** the second cooling means comprise an open conduit system with at least one feed conduit which can extend into the underground water table and through which groundwater can be suctioned up.

3. Cooling system as claimed in claim 1 or 2, **characterized in that** the second cooling means comprise an open conduit system with at least one discharge conduit which can extend into the underground water table and through which the groundwater can be discharged.

4. Cooling system as claimed in claim 1, **characterized in that** the second cooling means comprise a substantially closed conduit system which can extend at least into the ground, wherein the conduit system is provided with the second cooling medium.

5. Cooling system as claimed in any of the foregoing claims, **characterized in that** the conduit system can extend into the ground to a depth of at least 6 m.

6. Cooling system as claimed in any of the foregoing claims, **characterized in that** at least a part of the conduit system runs approximately horizontally after arranging thereof in the ground.

7. Cooling system as claimed in any of the foregoing claims, **characterized in that** the conduit system has a total length such that the second cooling medium will almost have the average temperature of the ground when it enters the first cooling means.

8. Cooling system as claimed in any of the foregoing claims, **characterized in that** the second cooling means are provided with at least one filter along which the second cooling medium can be guided.

9. Cooling system as claimed in any of the foregoing claims, **characterized in that** the second cooling means comprise at least one heat exchanger for heat exchange between the second cooling medium and the ground.

10. Cooling system as claimed in any of the foregoing claims, **characterized in that** the first cooling means comprise at least one heat exchanger for heat exchange between the second and the first cooling medium.

11. Cooling system as claimed in claim 10, **characterized in that** the first cooling means comprise a heat exchanger with a first space in which the first cooling medium can flow, and a second space in which the second cooling medium can flow, and heat-conducting means therebetween and in thermal contact with both spaces and comprising a large number of heat-conducting threads in the form of a strip or mat.

12. Cooling system as claimed in any of the foregoing claims, **characterized in that** the first cooling means comprise at least one fan for circulating the first cooling medium.

13. Cooling system as claimed in any of the foregoing claims, **characterized in that** the first cooling medium comprises air present in the electronic device.

14. Cooling system as claimed in any of the foregoing claims, **characterized in that** it is also provided with a drip-tray and drain for condensation water.

15. Use of a cooling medium cooled by means of heat exchange with the ground for the purpose of cooling electronic devices.

16. Electronic device provided with connections for the second cooling means of the cooling system as claimed in any of the foregoing claims.

17. Conduit system evidently intended as component of the second cooling means of the cooling system as claimed in any of the foregoing claims.
